# EUROPEAN PATENT SPECIFICATION

(11) **EP 0 245 048 B1**
(45) Date of publication and mention of the grant of the patent: **03.02.1993**
(21) Application number: 87303936.6
(22) Date of filing: 01.05.1987
(51) Int. Cl.: H03D 9/06

(54) **Finline millimeter wave detector**
Millimeterwellendetektor in einer Flossenleitung
Détecteur d'ondes millimétriques sur une ligne à ailettes

(30) Priority: 08.05.1986 US 861035
(43) Date of publication of application: 11.11.1987
(73) Proprietor: Hewlett-Packard Company, Palo Alto, California 94304 (US)
(72) Inventor: Upham, Herbert L., Sebastopol California 95472 (US)
(74) Representative: Colgan, Stephen James

(56) References cited:
- EP-A- 0 244 105
- GB-A- 2 161 990
- US-A- 4 425 549
- IEEE TRANSACTIONS ON MICROWAVE THEORY AND TECHNIQUES, vol. MTT-31, no. 2, February 1983, pages 142-146, IEEE, New York, US; W. MENZEL et al.: "Integrated fin-line components and subsystems at 60 and 94 GHZ"
- 10TH EUROPEAN MICROWAVE CONFERENCE PROCEEDINGS, Warszawa, 8th-12th September 1980, pages 722-726, Microwave Exhibitions and Publishers Ltd, Kent, GB; R. KNOECHEL et al.: "Octave-band double-balanced integrated finline mixers at mm-wavelengths"
- ARCHIV FÜR ELEKTRONIK UND ÜBERTRAGUNGSTECHNIK, vol. 36, no. 2, February 1982, pages 49-56, Würzburg, DE; H.E. HENNAWY et al.: "Computer-aided design of fin-line detectors, modulators, and switches"
- PATENT ABSTRACTS OF JAPAN, vol. 8, no. 281 (E-286)[1718], 21st December 1984; & JP-A-59 148 403 (NIPPON DENSHIN DENWA KOSHA) 25-08-1984
- MICROWAVE JOURNAL, vol. 28, no. 12, December 1985, pages 30,32,34,36,40,42,44,46,48, Dedham, Massachusetts, US; P.J. MEIER: "Integrated finline: the second decade part II"
- WISSENSCHAFTLICHE BERICHTE AEG-TELEFUNKEN, vol. 54, no. 4-5, 1981, pages 233-234, Frankfurt/Main, DE; H. MEINEL: "Millimeterwellen-Detektoren in Finleitungstechnik"

## Description

### Background of the Invention

This invention relates to microwave signal detection and more particularly to a millimeter wave detector using finline technology. The invention described herein is particularly useful for detection of microwave energy in a waveguide which is designed for a fundamental frequency above about twenty-five GHz. In particular, the invention is described with respect to frequencies of interest between about 30 and 50 GHz or between about 40 and 60 GHz. As used herein, wide bandwidth refers to a range of frequencies of approximately 20 GHz for a reference frequency of between about 30 and 60 GHz.

Heretofore, most microwave waveguide detection devices have employed precision machined conventional waveguide technology. The accuracy of machining of parts becomes of critical importance with shorter wavelengths of interest. For example, wavelengths of interest include those on the order of five (5) mm/ at about sixty (60) GHz. A significant problem with detectors for such high frequencies and short wavelengths is inherently poor impedance match between the detection diode and the waveguide, which results in loss of power as represented by a VSWR as great as 3:1. Other problems will be apparent hereinafter.

Because of problems with respect to the structure of conventional waveguide detectors involving high precision probes and cavity shaping, it has been suggested that finline technology be employed. One such suggestion is found in a paper published by Holger Meinel and Lorenz-peter Schmidt of AEG-Telefunken entitled "High Sensitivity Millimeter Wave Detectors using Fin-Line Technology", Conference Digest of Fifth International Conference on Infrared & Millimeter Waves, Wuerzburg, West Germany, 1980, pages 133-135. Therein the authors suggest the use of a millimeter wave detector using finline technology in which a Schottky diode is used as a detection element. The structure uses a quartz substrate mounted in a waveguide.

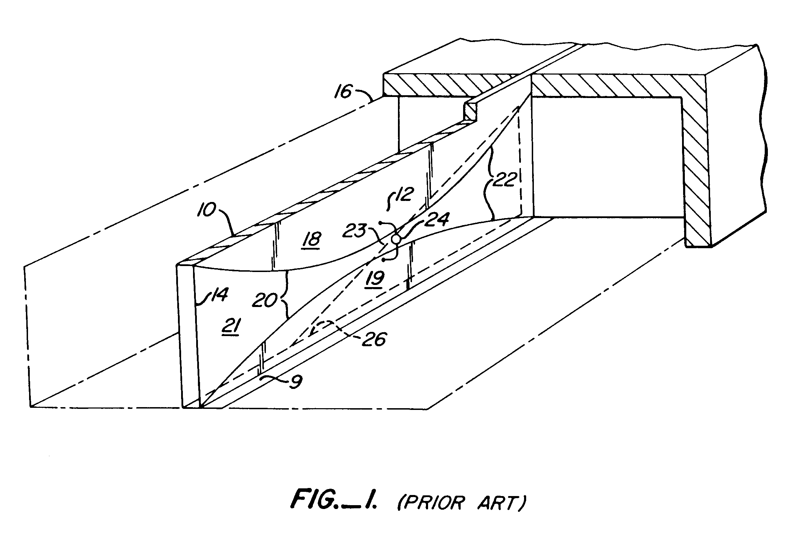

Figure 1 herein represents a finline structure 10 reconstructed from the brief description in the Meinel et al. paper. It shows a dielectrically loaded finline circuit 12 on a quartz dielectric substrate 14 in a waveguide 16. (Interior waveguide boundaries are shown partially in phantom. In the cited publication, surface and waveguide boundaries are not illustrated.) Metallization layers 18, 19 on the front surface 21 of the dielectric substrate 14 are shown to be provided, the layers 18, 19 having in surface pattern an input taper 20 and an output taper 22. At the point of minimum exposed dielectric width 23, there is shown a junction between a first metallization layer 18 and a second metallization layer 19 through a zero-bias Schottky diode 24. Significantly, the diode is mounted across the finline gap, that is, across the waveguide and in shunt with the finline transmission line. In a structure wherein a diode is mounted across a waveguide or across a finline gap, there is substantial sensitivity to diode parameters such as impedance, particularly frequency dependent impedance. Typically microwave frequency detection diodes have a characteristic impedance in the range of 30 ohms. This impedance must be matched to a characteristic impedance in a waveguide of on the order of 100 ohms. In the past, provision was made for impedance match between the diode structure and the waveguide, such as through various forms of transformers, matching networks and absorbers. Nevertheless, the bandwidth of a detector is limited because the characteristic capacitance of a real diode is not zero. Such finite capacitance has a measurable deleterious effect on the desired match, or return loss, of a detector structure. What is therefore needed is a detector structure which minimizes the effect of finite capacitance in a detection diode.

### SUMMARY OF THE INVENTION

According to the invention, a finline detector comprises a dielectric substrate-mounted circuit disposed within a millimeter waveguide, said substrate circuit comprising a substrate with a diode mounted thereon in series with the waveguide. The mounting of a diode, which may have a characteristic impedance substantially lower than the characteristic impedance of a realizable finline, in series with the waveguide transmission line minimizes sensitivity to the high capacitance and therefore low impedance realizable with such a detection diode. Furthermore, the transmission line may be terminated more easily in a wideband termination, thus increasing the effective bandwidth of operation of the detector. Two representative embodiments of the invention are, for example, an unbalanced detector and a balanced detector. Each embodiment includes a detection device, namely a diode, coupled in series with the finline transmission line. Capacitance means are also provided.

The invention will be better understood by reference to the following detailed description in connection with the accompanying drawings.

### BRIEF DESCRIPTION OF THE DRAWINGS

Fig. 1 is a perspective view of a prior art finline detector.

Fig. 2 is a top plan view of a finline detector in accordance with one embodiment of the invention.

Fig. 3 is a top plan view of a finline detector in accordance with another embodiment of the invention.

### DESCRIPTION OF SPECIFIC EMBODIMENTS

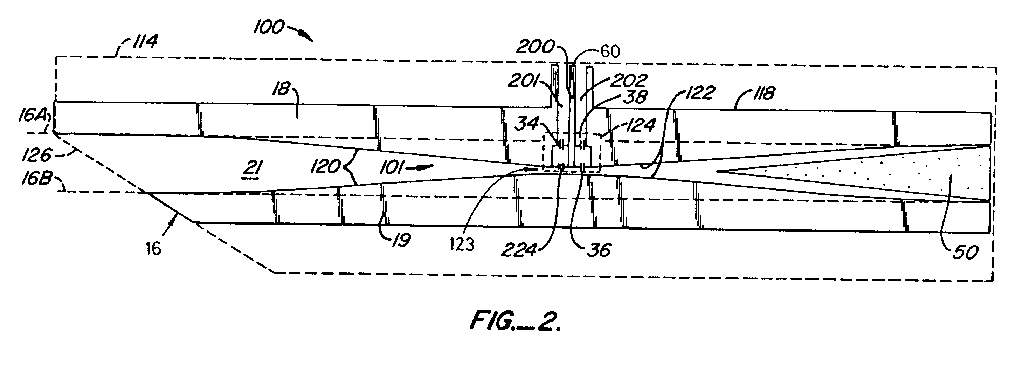

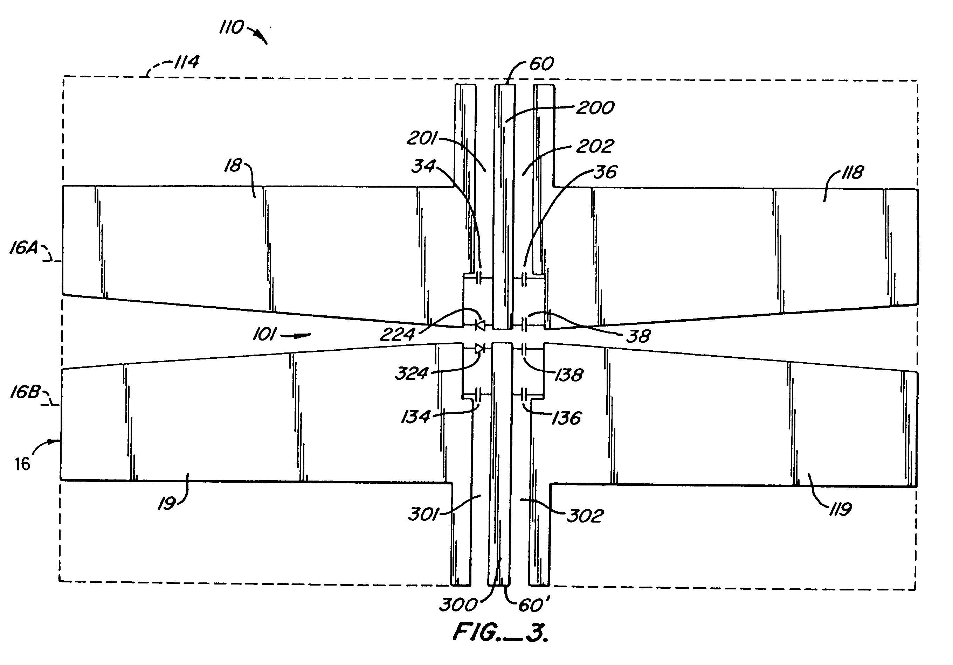

Referring now to the drawings, Figure 1, as previously discussed, depicts one suggestion in the published literature of a finline detection device. Figures 2 and 3 illustrate embodiments of the present invention. In Figure 2, there is shown a structure of a finline circuit 100 mounted within the interior boundaries of a waveguide. Interior boundaries or upper and lower walls 16A and 16B of the waveguide are depicted in phantom. A typical waveguide is a Type WR-19 waveguide designed for a center frequency of 60 GHz. The interior cross-sectional dimension of a standard WR-19 waveguide is 2.39 mm height by 4.78 mm width. The waveguide is typically comprised of mating U-shaped longitudinal sections wherein a finline substrate is sandwiched between the sections exposing the finline circuit 100 between the upper and lower walls 16A and 16B.

According to the invention, a finline circuit 100 formed on a dielectric substrate 114, which is mounted within a waveguide and extending between interior walls 16A, 16B in the narrower (height) dimension, is provided with a detection means 124 mounted in series with the finline transmission line between a first metallization layer 18 and a second metallization layer 118 on at least one side of a finline channel 101 of the finline circuit 100. In the specific embodiment of Figure 2, metallization layers 18, 19 and 118 on the front surface 21 of the dielectric substrate 114 are provided, the layers 18, 19 defining input tapers 120, and the layers 118 and 19 defining output tapers 122 in the surface pattern. First metallization layer 18 and second metallization layer 118 are separated by a first finline trace 200 set off by a first dielectric channel 201 and a second dielectric channel 202. The first finline trace 200 is disposed transverse of the waveguide and preferably at right angles to the finline channel 101. The first finline trace 200 is for carrying signals from the detection means to a terminal 60 and circuitry external of the waveguide through first waveguide wall 16A.

According to the invention, a first detection diode means 224 is provided between first metallization layer 18 and first trace 200 adjacent the finline channel 101. In a particular embodiment, the cathode terminal of the diode means 224 is coupled to the first metallization layer 18 and the anode terminal of the diode means is coupled to the first finline trace 200.

The detection means 124 may comprise an element containing the diode means, such as a low-barrier or a zero-bias Schottky diode, and lumped-element capacitance means 34 in parallel therewith for voltage detection with some impedance effect. However, the principal impedance is that of the diode means 224. Alternatively, a lumped capacitor 34 may be placed adjacent the diode means 224 between the first metallization layer 18 and third metallization layer 118. In addition, capacitance means 36, 38 may be disposed between the first trace 200 and third metallization layer 118 adjacent the finline channel 101 and across second dielectric channel 202. The capacitance means 36, 38 provide for r.f. continuity along the finline channel 101 and decoupling of r.f. signals from the first finline trace 200 at the junction with the waveguide wall 16A. The purpose of capacitance means in general adjacent a detection means is to maintain d.c. voltage on the d.c.-isolated first finline trace 200 during detection of an r.f. signal.

In the specific embodiment, an energy absorber 50 is provided on the surface 21 of the dielectric substrate 100 downstream of the site of the detection means 124. The absorber 50 is preferably wedge shaped, that is, tapered from a minimum to a maximum channel width along the finline channel 101. Alternatively, other suitable matching arrangements may be provided.

The dielectric substrate 100 may be shaped or provided with a taper to introduce a smooth impedance transition from a free-space waveguide to a dielectrically-loaded waveguide of a relatively high dielectric coefficient. To this end, the dielectric substrate 100 may be provided with a leading edge 126 which defines a gradual taper along the length of the waveguide 16 from one wall 16A to the opposing wall 16B. The leading edge 126 is preferably tapered from zero waveguide height to maximum waveguide height at an angle not exceeding thirty (30) degrees. A straight taper is simple and convenient for manufacturing purposes, and it provides for orderly impedance transition without requiring an absorber to inhibit undesired reflection of energy incident on the finline structure 100. The thickness of the dielectric substrate 114 may be on the order of 0.25 mm, which is consistent with the thickness of a simple dielectric sheet in a dielectrically-loaded waveguide.

The metallization layers 18, 19 and 118 may be formed of any highly conductive material which bonds to the surface of the substrate material. The metallization layers may be formed of gold or silver. Gold is preferred due to its high conductivity and its corrosion resistance.

The minimum separation between metallization layer 18 and metallization layer 19 is preferably about 0.15 mm at the detection means 124. The surface tapers 120 and of the metallization layers 18 and 19, respectively, extend preferably about 1.3 wavelengths (when measured at the center or design frequency of the waveguide) to the detection region 123.

The advantages of the invention are readily apparent upon attempted impedance match between the characteristic impedance of the finline channel 101 and the diode means 224. The diode means 224 exhibits intrinsic junction capacitance (not depicted) and intrinsic resistance which must be counteracted if detection sensitivity is not to degrade with decreasing wavelengths of operation. One purpose of the absorber 50 is to suppress reflections resulting from impedance mismatch. If a shunt inductance were provided across the intrinsic junction capacitance of the diode means, some of the problem could be alleviated. According to the invention, however, the effect of junction capacitance is minimized by placement of the diode means substantially along the wall 16A of the waveguide. The inductance required to cancel the intrinsic capacitance is thus reduced. The designer also has a greater choice of suitable diode means, since design is no longer governed principally by intrinsic capacitance of the diode means 224.

The embodiment of Figure 2 shows a finline detector 100 with unbalanced detection. The embodiment of Figure 3 illustrates a finline detector 110 according to the invention with balanced detection. Identical numerals reflect identical features in Figure 2 and Figure 3. In addition, the embodiment of Figure 3 includes a second diode means 324, the second diode means 324 being disposed with its cathode coupled to a second finline trace 300 and its anode coupled to the second metallization layer 19 such that full wave rectification is provided. (Externally, the first trace 200 and the second trace 300 may be coupled to a common terminal 60, 60'.) The second trace 300 is disposed between a third dielectric channel 301 and a fourth dielectric channel 302 in a mirror image of the first trace 200, first channel 201, and second channel 202. Fourth capacitance means 134 is provided in parallel with second diode means 324 across third dielectric channel 301, and capacitance means, specifically fourth capacitance means 136 and fifth capacitance means 138, are coupled between second trace 300 and a fourth metallization layer 119. Thus, a balanced finline detector 110 in accordance with the invention is identical to a pair of unbalanced finline detectors 100 in mirror image to one another.

In operation of the circuit, whenever an r.f. signal is applied to a waveguide containing the finline circuit 100 or 110 according to the invention, an a.c. (e.g., sinusoidal) voltage is developed along the finline channel 101 between the forward metallization layer 18 or 19 and the respective first or second trace 200 and 300. A voltage difference may also appear across the finline channel 101. The nonlinear element, namely the diode means 224 (and 324 in the balanced version) will conduct current in a sense or direction such that a differential d.c. voltage will appear on the trace 200 (and 300 in the balanced version). The capacitance means 38 (and 138) provide an r.f. signal path through the metallization layers 18, 118 and 19, 119. The capacitance means 34, 36, 38 (and 134, 136 and 138) also serve to maintain the d.c. voltage on the traces for voltage level detection, as well as to provide a good r.f. path between metallization layers. Signals are picked off at output terminals of traces 200 and 300 external to the walls 16A and 16B of the waveguide and supplied to a buffer amplifier (not shown) for processing.

The invention has now been explained with reference to specific embodiments. Other embodiments will be apparent to those of ordinary skill in the art. It is therefore not intended that the invention be limited except as indicated by the appended claims.

## Claims

1. A microwave finline apparatus (100) for detecting microwave energy in a waveguide (16) said apparatus including a dielectric substrate (114) disposed within said waveguide (16) and extending between opposing first and second interior walls (16A,16B) of said waveguide (16), said dielectric substrate (114) having thereon metallization (18,19,118) on a first substantially planar dielectric surface (21), said metallization (18,19,118) including at least a first metallization layer (18) and a second metallization layer (19) defining at least a channel region (101) of exposed dielectric surface (21) between a first side and a second side of said channel region (101) formed of opposing margins (120) of said first metallization layer (18) and said second metallization layer (19), characterized by:
at least a first trace (200) between said channel region (101) and a first terminal (60) external of the waveguide, said at least first trace (200) being electrically insulated from said first metallization layer (18); and
first diode means (224) disposed between said first metallization layer (18) and said first trace (200) along said first side of said channel region (101) for detecting an r.f. signal.

2. The finline apparatus (100) of claim 1 further characterized by first capacitance means (34) disposed between said first metallization layer (18) and said first trace (200) in parallel electrical connection with said first diode means (224).

3. The finline apparatus (100) of claim 1 or 2 further characterized by:
a third metallization layer (118) forming a portion of said first side of said channel region (101) and disposed adjacent said first trace (200); and
second capacitance means (38) disposed between said first trace (200) and said third metallization layer (118).

4. A finline apparatus (110) according to claim 1, 2 or 3 further characterized by:
at least a second trace (300) between said channel region (101) and a second terminal (60ʹ) external of the waveguide, said at least second trace (300) being electrically insulated from said second metallization layer (19); and
second diode means (324) disposed between said second metallization layer (19) and said second trace (300) along said second side of said channel region (101) opposing said first diode means (224) and in anti-parallel relation with said first diode means (224) to provide a balanced apparatus for detecting an r.f. signal.

5. The finline apparatus (110) of claim 4 further characterized by third capacitance means (134) disposed between said second metallization layer (19) and said second trace (300) in parallel electrical connection with said second diode means (324).

6. A finline apparatus (110) in accordance with claims 1 through 5 further characterized by: a fourth metallization layer (119) forming a portion of said second side of said channel region (101) and disposed adjacent said second trace (300); and
fourth capacitance means (138) disposed between said second trace (300) and said fourth metallization layer (119).

7. The finline apparatus (100 or 110) of claims 3 through 6 wherein said second capacitance means includes a first capacitor (36) disposed between said first trace (200) and said third metallization layer (118) adjacent said first interior wall (16A) of said waveguide and a second capacitor (38) disposed between said first trace (200) and said third metallization layer (118)adjacent said channel region (101).

8. The finline apparatus (100 or 110) of claims 1 through 7 further characterized by means (50) for electrically terminating said channel region (101).

9. The finline apparatus (100 or 110) of claim 8 further characterized in that said terminating means (50) includes means for absorbing r.f. energy in said channel region (101).

## Patentansprüche

1. Eine Mikrowellen-Finnenleitungsvorrichtung (100) zum Erfassen einer Mikrowellen-Energie in einem Wellenleiter (16) mit einem dielektrischen Substrat (114), das innerhalb des Wellenleiters (16) angeordnet ist und sich zwischen gegenüberliegenden ersten und zweiten Innenwänden (16A, 16B) des Wellenleiters (16) erstreckt, wobei auf dem dielektrischen Substrat (114) eine Metallisierung (18, 19, 118) auf einer ersten, im wesentlichen ebenen dielektrischen Fläche (21) vorgesehen ist, wobei die Metallisierung (18, 19, 118) wenigstens eine erste Metallisierungsschicht (18) und eine zweite Metallisierungsschicht (19) umfaßt, die wenigstens einen Kanalbereich (101) einer freiliegenden dielektrischen Oberfläche (21) zwischen einer ersten Seite und einer zweiten Seite des Kanalbereiches (101) festlegen, welcher durch gegenüberliegende Ränder (120) der ersten Metallisierungsschicht (18) und der zweiten Metallisierungsschicht (19) festgelegt wird, gekennzeichnet durch:
wenigstens eine erste Leiterbahn (200) zwischen dem Kanalbereich (101) und einem ersten Anschluß (60) außerhalb des Wellenleiters, wobei die zumindest eine erste Leiterbahn (200) elektrisch von der ersten Metallisierungsschicht (18) isoliert ist; und
eine ersten Diodeneinrichtung (224), die zwischen der ersten Metallisierungsschicht (18) und der ersten Leiterbahn (200) längs der ersten Seite des Kanalbereiches (101) zum Erfassen eines Hochfrequenzsignales angeordnet ist.

2. Die Finnenleitungsvorrichtung (100) nach Anspruch 1, ferner gekennzeichnet durch eine erste Kapazitätseinrichtung (34), die zwischen der ersten Metallisierungsschicht (18) und der ersten Leiterbahn (200) in paralleler elektrischer Verbindung mit der ersten Diodeneinrichtung (224) angeordnet ist.

3. Die Finnenleitungsvorrichtung (100) nach Anspruch 1 oder 2, ferner gekennzeichnet durch:
eine dritte Metallisierungsschicht (118), die einen Abschnitt der ersten Seite des Kanalbereiches (101) bildet und nahe der ersten Leiterbahn (200) angeordnet ist; und
eine zweite Kapazitätseinrichtung (38), die zwischen der ersten Leiterbahn (200) und der dritten Metallisierungsschicht (118) angeordnet ist.

4. Eine Finnenleitungsvorrichtung (110) nach einem der Ansprüche 1, 2 oder 3, ferner gekennzeichnet durch:
wenigstens eine zweite Leiterbahn (300) zwischen dem Kanalbereich (101) und einem zweiten Anschluß (60') außerhalb des Wellenleiters, wobei die zumindest eine zweite Leiterbahn (300) elektrisch von der zweiten Metallisierungsschicht (19) isoliert ist; und
eine zweite Diodeneinrichtung (324), die zwischen der zweiten Metallisierungsschicht (19) und der zweiten Leiterbahn (300) längs der zweiten Seite des Kanalbereiches (101) gegenüber der ersten Diodeneinrichtung (224) und in antiparalleler Beziehung zu der ersten Diodeneinrichtung (224) angeordnet ist, um eine symmetrische Vorrichtung zum Erfassen eines Hochfrequenzsignales zu schaffen.

5. Die Finnenleitungsvorrichtung (110) nach Anspruch 4, ferner gekennzeichnet durch eine dritte Kapazitätseinrichtung (134), die zwischen der zweiten Metallisierungsschicht (19) und der dritten Leiterbahn (300) in paralleler elektrischer Verbindung mit der zweiten Diodeneinrichtung (324) angeordnet ist.

6. Eine Finnenleitungsvorrichtung (110) nach den Ansprüchen 1 bis 5, ferner gekennzeichnet durch:
eine vierte Metallisierungsschicht (119), die einen Teil der zweiten Seite des Kanalbereiches (101) bildet und nahe der zweiten Leiterbahn (300) angeordnet ist; und
eine vierte Kapazitätseinrichtung (138), die zwischen der zweiten Leiterbahn (300) und der vierten Metallisierungsschicht (119) angeordnet ist.

7. Die Finnenleitungsvorrichtung (100 oder 110) nach den Ansprüchen 3 bis 6, bei der die zweite Kapazitätseinrichtung einen ersten Kondensator (36) umfaßt, der zwischen der ersten Leiterbahn (200) und der dritten Metallisierungsschicht (118) nahe der ersten Innenwand (16A) des Wellenleiters angeordnet ist, und bei der ein zweiter Kondensator (38) zwischen der ersten Leiterbahn (200) und der dritten Metallisierungsschicht (118) nahe des Kanalbereiches (101) angeordnet ist.

8. Die Finnenleitungsvorrichtung (100 oder 110) nach den Ansprüchen 1 bis 7, ferner gekennzeichnet durch eine Einrichtung (50) zum elektrischen Abschließen des Kanalbereiches (101).

9. Die Finnenleitungsvorrichtung (100 oder 110) nach Anspruch 8, ferner dadurch gekennzeichnet, daß die Abschlußeinrichtung (50) eine Einrichtung zum Absorbieren von Hochfrequenzenergie in dem Kanalbereich (101) umfaßt.

## Revendications

1. Dispositif de ligne à ailettes micro-ondes (100) pour détecter une énergie micro-ondes dans un guide d'onde (16), ledit dispositif incluant un substrat diélectrique (114) disposé à l'intérieur dudit guide d'onde (16) et s'étendant entre des première et seconde parois internes opposées (16A, 16B) dudit guide d'onde (16), ledit substrat diélectrique (114) comportant sur lui une métallisation (18, 19, 118), sur une première surface diélectrique sensiblement plane (21), ladite métallisation (18, 19, 118) incluant au moins une première couche de métallisation (18) et une seconde couche de métallisation (19) définissant au moins une région de canal (101) de la surface diélectrique à nu (21) entre un premier côté et un second côté de ladite région de canal (101) formés par des bords opposés (120) de ladite première couche de métallisation (18) et de ladite seconde couche de métallisation (19),
caractérisé par :
au moins un premier tracé (200) disposé entre ladite région de canal (101) et une première borne (60) externe au guide d'onde, ledit au moins premier tracé (200) étant électriquement isolé de ladite première couche de métallisation (18) ; et
un premier moyen de diode (224) disposé entre ladite première couche de métallisation (18) et ledit premier tracé (200) le long dudit premier côté de ladite région de canal (101) pour détecter un signal radio-fréquence.

2. Dispositif de ligne à ailettes (100) selon la revendication 1, caractérisé en outre par un premier moyen de capacité (34) disposé entre ladite première couche de métallisation (18) et ledit premier tracé (200) selon une connexion électrique parallèle audit premier moyen de diode (224).

3. Dispositif de ligne à ailettes (100) selon la revendication 1 ou 2, caractérisé en outre par :
une troisième couche de métallisation (118) qui forme une partie dudit premier côté de ladite région de canal (101) et qui est disposée de manière à être adjacente audit premier tracé (200) ; et
un second moyen de capacité (38) disposé entre ledit premier tracé (200) et ladite troisième couche de métallisation (118).

4. Dispositif de ligne à ailettes (110) selon la revendication 1, 2 ou 3, caractérisé en outre par :
au moins un second tracé (300) disposé entre ladite région de canal (101) et une seconde borne (60') externe au guide d'onde, ledit au moins second tracé (300) étant électriquement isolé de ladite seconde couche de métallisation (19) ; et
un second moyen de diode (324) disposé entre ladite seconde couche de métallisation (19) et ledit second tracé (300) le long dudit second côté de ladite région de canal (101) opposé audit premier moyen de diode (224) et selon une relation antiparallèle par rapport audit premier moyen de diode (224) afin de produire un dispositif équilibré pour détecter un signal radio-fréquence.

5. Dispositif de ligne à ailettes (110) selon la revendication 4, caractérisé en outre par un troisième moyen de capacité (134) disposé entre ladite seconde couche de métallisation (19) et ledit second tracé (300) selon une connexion électrique parallèle audit second moyen de diode (324).

6. Dispositif de ligne à ailettes (110) selon la revendication 1 à 5, caractérisé en outre par :
une quatrième couche de métallisation (119) qui forme une partie dudit second côté de ladite région de canal (101) et qui est disposée de manière à être adjacente audit second tracé (300) ; et
un quatrième moyen de capacité (138) disposé entre ledit second tracé (300) et ladite quatrième couche de métallisation (119).

7. Dispositif de ligne à ailettes (100, 110) selon la revendication 3 à 6, dans lequel ledit second moyen de capacité inclut une première capacité (36) disposée entre ledit premier tracé (200) et ladite troisième couche de métallisation (118) de manière à être adjacente à ladite première paroi interne (16A) dudit guide d'onde et une seconde capacité (38) disposée entre ledit premier tracé (200) et ladite troisième couche de métallisation (118) de manière à être adjacente à ladite région de canal (101).

8. Dispositif de ligne à ailettes (100 ou 110) selon la revendication 1 à 7, caractérisé en outre par un moyen (50) pour limiter électriquement ladite région de canal (101).

9. Dispositif de ligne à ailettes (100 ou 110) selon la revendication 8, caractérisé en outre en ce que ledit moyen de limitation (50) inclut un moyen pour absorber une énergie radio-fréquence dans ladite région de canal (101).
